# DEMANDE DE BREVET EUROPEEN

(11) **EP 0 557 152 A1**
(43) Date de publication de la demande: **25.08.1993**
(21) Numéro de dépôt: 93400263.5
(22) Date de dépôt: 03.02.1993
(51) Int. Cl.: H01L 21/331, H01L 29/73, H01L 21/20

(54) **Procédé de fabrication de structures actives et dispositifs semiconducteurs ainsi obtenus**

(30) Priorité: 05.02.1992 FR 9201293
(71) Demandeur: FRANCE TELECOM, F-75015 Paris (FR)
(72) Inventeur: Launay, Patrick, F-92120 Montrouge (FR)
(74) Mandataire: Dubois-Chabert, Guy

(57) **Abrégé**

La présente invention concerne un procédé de fabrication de structures actives et les dispositifs semicondcuteurs qui en sont obtenus. Elle trouve application dans le domaine de la fabrication de composants semiconducteurs comme des diodes ou des transistors ou de la fabrication de circuits intégrés. En particulier, elle concerne la réalisation de transistors bipolaires à hétérojonction.

Selon l'invention, on exécute des creusements (61, 63) et des remplissages successifs (62, 69, 73), par épitaxies sélectives de façon à, pour réaliser une structure active verticale comme un transistor bipolaire à hétérojonction, faire remonter vers la surface des parties de contactage (65, 71) et/ ou des parties d'isolation (66, 67).

## Description

La présente invention concerne un procédé de fabrication de structures actives et les dispositifs semiconducteurs qui en sont obtenus. Elle trouve application dans le domaine de la fabrication de composants semiconducteurs comme des diodes ou des transistors ou de la fabrication de circuits intégrés. En particulier, elle concerne la réalisation de transistors bipolaires à hétérojonction.

Selon l'invention, on s'est aperçu que la planéité et l'auto- alignement de structures actives, notamment comme des structures bipolaires, à effet de champ, à hétérojonction et d'autres encore, n'étaient pas facilement assurées dans les technologies actuellement mises en oeuvre.

En effet, jusqu'à présent les opérations qui consistent à aller chercher, à travers l'empilement vertical des couches actives, une couche pour y réaliser un contact, mettent en oeuvre des solutions technologiques telles que l'on a rarement le contrôle à la fois de l'alignement et de la planéité. On obtient ainsi des structures non parfaitement planes ou dans lesquelles il faut rajouter une étape de photolithographie pour l'alignement des structures et de leurs contacts.

L'invention permet de porter remède à cet inconvénient de l'art antérieur.

En effet, l'invention concerne un procédé de fabrication de structures actives ou d'au moins une structure active semiconductrice multicouches sur un substrat, en matériaux III-V,
caractérisé en ce qu'il consiste à réaliser une succession de creusements et de remplissages des dits creusements ainsi réalisés à l'aide d'épitaxies sélectives d'au moins un matériau correspondant à l'une des dites couches ou groupe de couches, de telle sorte que, à chaque étape de remplissage on réalise la remontée en surface de la structure finale d'une partie de contactage d'au moins une couche ou groupe de couches et/ou une isolation des dites parties de remontée de contactage et des dispositifs.

Le procédé de l'invention n'est pas exclusif de l'exécution concurrente d'autres procédés de fabrication permettant notamment de creuser, de remplir ou de faire croître une couche ou un groupe de couches, ainsi que des procédés pour réaliser des dessins particuliers permettant de réaliser les structures les plus diverses.

Dans un mode de réalisation, le remplissage d'un creusement est réalisé par reprise d'épitaxie depuis la couche la plus profonde dégagée dans le creusement jusqu'au niveau de surface.

Dans un autre mode de réalisation, quand la structure active est réalisée sur un substrat semi-isolant, il est possible de réaliser directement l'isolation entre structures actives voisines d'un circuit intégré. Selon une première façon de réaliser cette isolation, le substrat semi isolant est creusé de plusieurs creux, dont le remplissage ultérieur par les couches constituant les structures actives fait apparaître ultérieurement un réseau de structures actives qu'il est possible de relier électriquement, ou aut:ement, les unes aux autres pour réaliser des circuits intégrés complexes.

Selon une seconde façon de réaliser cette isolation, les couches des structures actives sont réalisés sur au moins une partie correspondante du substrat. Puis, on exécute un creusement dans des zones de séparation électrique entre structures actives. Puis, pour réaliser l'isolation, on réalise une reprise sélective d'épitaxie du matériau du substrat de façon à remplir chacun des dits creux, par un matériau semi- isolant.

Dans une troisième façon de réaliser cette isolation, on dépose un matériau isolant su le substrat, au sein duquel on réalise des ouvertures localisées par gravure de l'isolant pour faire apparaître le matériau du substrat. Puis, on réalise par une épitaxie non sélective la croissance des couches des structures actives. On obtient ainsi un polycristal isolant sur le matériau isolant de départ et la structure cristalline des couches qui constituent les dispositifs sur le matériau du substrat prélablement dégagé.

Dans un autre mode de réalisation de l'invention, pour la réalisation directe de chaque structure active comme un transistor obtenue par empilement vertical des couches, le creusement est réalisé dans l'ensemble des couches que l'on veut traverser. Puis, on réalise la reprise d'épitaxie notamment en disposant des espaceurs isolants sur les parois verticales du creusement pour réaliser une isolation locale de la remontée de connexion de contact.

Dans un mode de réalisation, l'ensemble des couches est réalisé par remplissages et creusements successifs jusqu'à effleurement sur la surface du substrat semi-isolant, ce qui permet d'obtenir la remontée de n - 1 couches enterrées sous la couche supérieure par une succession latérale de n zones d'implantation de contacts. Les couches actives, par exemple d'un transistor bipolaire à hétérojonction, sont réalisées successivement, de telle sorte que les couches de contact électrique apparaissent en surface, sans aucune opération technologique supplémentaire.

Dans certaines structures actives, il est possible que certaines des couches de contact ne soient pas remontées de cette façon, mais seulement par creusement et remontée en surface par une reprise d'épitaxie d'une couche de contact située en profondeur.

Dans un autre mode de réalisation de l'invention, on exécute aussi la fabrication d'une structure bipolaire à hétérojonction qui permet d'obtenir un transistor bipolaire à hétérojonction ou un circuit intégré comportant une telle structure et qui permet de résoudre un certain nombre de problèmes particuliers rencontrés lors de la fabrication de ces dispositifs.

Dans l'art antérieur, on a déjà proposé des structures actives consistant en transistors en matériaux composites des groupes III-V. Ces dispositifs sont fabriqués par couches successives de matériaux composites en réalisant, lors de la fabrication, une insertion d'impuretés de dopage. De tels matériaux composites sont par exemple réalisés à partir d'un ou plusieurs corps pris parmi le gallium Ga, l'arsenic As et l'aluminium Al. On sait obtenir ainsi des jonctions semiconductrices successives qui permettent en particulier de réaliser des effets transistor de type bipolaire. Pour permettre un contrôle de la conduction entre deux électrodes respectivement d'émetteur et de collecteur, contactées sur une zone d'un dopage d'un premier type de conductivité (par exemple un dopage N), par une électrode de base contactée sur une zone implémentée au milieu de la première zone et d'un dopage d'un second type de conductivité (par exemple, une zone de dopage P). Un tel transistor est dit transistor bipolaire à hétérojonction si au moins l'une des couches précitées présente une largeur de bande interdite plus grande que celle des autres couches.

Pour tenir compte d'un certain nombre de phénomènes électroniques au niveau des porteurs de charge, il est connu d'utiliser par exemple des teneurs en composés qui varient en fonction de la position dans la jonction.

Cependant, deux problèmes particuliers doivent être résolus pour obtenir une augmentation de la rapidité des circuits intégrés et de leur densité d'intégration. Ce sont principalement la réalisation d'une structure plane d'une part, et d'autre part l'auto-alignement des contacts de base, d'émetteur et de collecteur.

Cette dernière caractéristique, quand on cherche à minimiser les distances critiques, permet d'accroître la performance fréquentielle du dispositif.

La structure et le fonctionnement d'un transistor bipolaire à hétérojonction, et ses applications, sont bien connus et sont décrits par exemple dans l'article de Herbert Kromer, "Heterostructure Bipolar Transistors and Integred Circuits", Proceeding of IEEE, volume 25, numéro 1, janvier 1982, et dans l'article de P.M. Asbeck et alter, "GaAlAs/GaAs Hétérojonction Bipolar Transistors : Issues and Prospects for Applications", IEEE Transactions on Electron Devices, volume 36, numéro 10, octobre 1989.

D'une manière générale, la définition d'un dispositif à hétérostructure utilise le fait que le dispositif présente des zones séparées dont l'une est réalisée en un matériau semiconducteur qui présente une bande interdite plus grande que celle des matériaux des autres zones.

En combinant de manière judicieuse les variations des bandes interdites et des champs électriques, il est donc possible, dans de larges limites, de contrôler les forces agissant sur les porteurs de charge, séparément et indépendamment pour les électrons ou les trous.

Dans l'article de Yang et alter, intitulé "Planar Heterojunction Bipolar Transistor with an Inplanted Base", Electronic Letters, volume 25, numéro 4, 1989, il est décrit une structure d'un transistor bipolaire à hétérojonction GaAlAs/GaAs totalement plan, mais qui n'est pas autoaligné. Dans une telle structure, on fait intervenir successivement :
- une épitaxie de la couche de contact du collecteur et de collecteur, suivie d'une implantation de type P pour réaliser la base dans le collecteur ;
- une épitaxie sélective pour réaliser l'émetteur suivie d'une nouvelle implantation de type P pour réaliser un contact de base ;
- une isolation par des tranchées et une implantation ionique ;
- réalisation des contacts ohmiques avec des matériaux non réfractaires.

Dans le document Mitani et alter, intitulé "Planarisation Technique for AlGaAs/GaAs Heterojunction Bipolar Transistors using Selective W-CVD", Conférence SOTAPOCS 1990, on a décrit la réalisation d'un contact ohmique de collecteur. Selon ce procédé, on dépose sélectivement du tungstène pour remplir un trou. Mais au préalable, il faut réaliser un dépôt d'un alliage Au-Ge/Pt dans ce trou pour préparer l'adhérence de surface du contact de tungstène dans le trou et réaliser le contact ohmique.

Dans le brevet européen EP- A- 0 184 016, on a proposé une structure plane réalisée par une succession d'implantations pour contacter la couche de base et la couche de collecteur et sur laquelle on réalisera ensuite des isolations. Mais cette technique ne permet pas la réalisation des trois contacts ohmiques avec un même métal réfractaire en tungstène.

Les contacts ohmiques sont en général réalisés avec de l'or, du nickel, du zinc ou encore du manganèse. Les métallurgies de ces matériau présentent plusieurs inconvénients.

Tout d'abord, les métallurgies sont différentes pour les contacts de type P et de type N, ce qui rend nécessaire la réalisation de deux étapes dans le procédé de fabrication de la structure à hétérojonction, puisqu'il faut des zones de conductivités différentes.

D'autre part, les contacts ne sont pas stables dès que la température excède 500°C.

On ne peut pas utiliser non plus les techniques de gravure par plasma.

Dans le procédé de fabrication d'un circuit intégré utilisant une structure à hétérojonction, il faut réaliser une isolation des différents dispositifs élémentaires du circuit intégré. Trois techniques sont couramment utilisées pour cette isolation.

Tout d'abord, on sait délimiter les transistors du circuit intégré par gravure. Mais dans ce cas, la gravure du dispositif rend celui-ci non plan.

Pour conserver la planéité tout en permettant une isolation, on réalise une implantation par des ions d'hydrogène et de bore. Mais cette implantation ionique présente deux limitations essentielles. D'une part, les doses et énergies d'implantation sont élevées, ce qui nécessite un masque épais qui est difficile à réaliser, notamment pour conserver les cotes. D'autre part, dès que la température excède environ 500°C, l'isolation n'est plus effective.

Enfin, on sait réaliser une isolation des transistors en réalisant des tranchées autour du transistor. Cette méthode permet de conserver la structure plane, mais la largeur de cette isolation est limitée à quelques microns. Il est en effet difficile de remplir un trou profond de grande largeur par un diélectrique tout en conservant la planéité. Cette technique ne permet donc pas de remplacer les couches sans utilité pour la réalisation des dispositifs par un isolant sur l'ensemble de la plaque. Or, ces couches sont conductrices. De ce fait, il faudra par la suite réaliser une nouvelle isolation pour éviter les courts-circuits lors de la réalisation des interconnexions entre transistors.

En fait, les transistors bipolaires à hétérojonction produits selon l'art antérieur n'étaient pas plans et s'ils l'étaient, ils utilisaient des contacts qui ne résistaient pas en haute température. Les techniques utilisées consistent à réaliser le contactage d'une base implantée en profondeur. Ceci est obtenu par l'implantation d'un dopant de type P, comme le magnésium, ou encore par une reprise d'épitaxie sur la couche qui constitue la base. Dans les deux cas, la couche de type N en profondeur est contactée par une gravure. De ce fait, la planéité n'est donc pas totalement assurée.

C'est un autre objet de l'invention de réaliser notamment un transistor bipolaire à hétérojonction, plan et autoaligné, ainsi qu'un circuit intégré qui peut être obtenu par connexion directe entre les différents transistors ou dispositifs constitués ainsi.

C'est un autre objet de l'invention de permettre de définir dès le départ du procédé de fabrication, les zones actives des circuits qui sont exécutés en reliant, selon des topogrammes prédéterminés, les structures actives obtenues selon le procédé de l'invention. De ce fait, on peut s'affranchir des contraintes ultérieures des procédés de fabrication de l'art antérieur, notamment au niveau des tolérances de définition des motifs. On permet ainsi d'accroître la densité d'intégration. En fait, on obtient aussi une isolation sur toute les surfaces non utilisées pour la réalisation des dispositifs, et on obtient aussi une surface plane.

En particulier, la suite de la description insistera sur des transistors bipolaires à hétérojonction constitués avec des composés Ga, As, Al. Mais l'invention concerne aussi des transistors bipolaires à plusieurs hétérojonctions, des transistors bipolaires à effet tunnel résonnant, à plan de dopage de base, à émetteur situé en dessus ou au dessous de la structure verticale du transistor, des transistors bipolaires réalisés avec d'autres méthodes, etc.

C'est un autre objet de l'invention de permettre de réaliser un contact de la couche N en profondeur. Cette couche N peut être allouée au collecteur ou à l'émetteur suivant la structure verticale adoptée. Le contact est réalisé par un matériau qui permet l'utilisation d'un métal réfractaire pour réaliser le contact ohmique.

C'est un autre objet de l'invention de permettre de réaliser tous les contacts ohmiques avec le même métal réfractaire. Ces contacts seront donc stables à haute température.

Il est ainsi possible dans un mode de réalisation de l'invention de réaliser en une seule étape les contacts ohmiques.

Un autre objet de l'invention est aussi de permettre des températures élevées dans le cours du procédé de fabrication des circuits intégrés et d'augmenter la fiabilité des contact ohmiques.

Dans un mode de réalisation de transistor GaAlAs/GaAs, le contact ohmique de base est obtenu par diffusion de zinc ou sur une couche de base fortement dopée ou d'une couche de remontée de base fortement dopée et dépôt d'un alliage métallique à base de tungstène. Ce mode de réalisation est applicable à la réalisation d'une couche de base avec une gradualité en aluminium, ce qui accroît la performance en fréquences des transistors.

C'est un autre objet de l'invention d'utiliser l'aluminium Al comme niveau d'interconnexions entre structures actives. Ces connexions électriques entre structures actives sont actuellement réalisées avec de l'or. Mais, une telle couche de connexion en or ne peut être gravée autrement que par usinage ionique. Or, l'usinage ionique est un procédé non sélectif vis à vis des autres matériaux qui sont utilisés pour réaliser les circuits intégrés. De ce fait, l'aluminium utilisé dans l'invention peut être gravé par plasma réactif de façon sélective vis à vis de la couche d'isolant placée sous les interconnexions.

Cette caractéristique avantageuse de l'invention est rendue possible puisque l'on réalise un contact entre l'aluminium et le tungstène. Ceci n'est pas possible avec les contacts ohmiques classiques qui incorporent de l'or à cause de l'incompatibilité métallurgique entre l'aluminium et l'or.

C'est un autre objet de l'invention de permettre, à la fin du procédé de fabrication, d'obtenir une structure plane permettant notamment un accroissement de la densité d'intégration.

C'est un autre objet de l'invention de permettre la réalisation d'une partie des interconnexions entre dispositifs pour obtenir des cellules de circuits électroniques de base. De ce fait, il est possible de réaliser facilement et d'implanter des bibliothèques de circuits de base qui permettent une réalisation plus facile des circuits intégrés à la demande.

D'autres caractéristiques et avantages de la présente invention seront maintenant décrits à l'aide de la description annexée et des figures qui sont :
Les figures 1 et 2 : deux étapes de fabrication, représentant l'isolation initiale d'un transistor bipolaire à hétérojonction selon un premier mode de réalisation de l'invention ;
La figure 3 : l'étape d'isolation initiale d'un transistor bipolaire à hétérojonction selon un second mode de réalisation de l'invention ;
La figure 4 : l'étape d'isolation initiale d'un dispositif selon un troisième mode de réalisation de l'invention ;
Les figures 5 à 9 : les étapes de réalisation d'un transistor autoaligné avec des contacts en tungstène selon un premier mode de réalisation du procédé de l'invention ;
Les figures 10 et 11 : une variante de ce procédé dans laquelle on réalise une implantation ionique pour réaliser une partie au moins de l'isolation ;
Les figures 12 à 16 : la description d'un procédé de réalisation selon un second mode de réalisation de l'invention qui permet d'obtenir une structure totalement plane sans passer par une reprise d'épitaxie de la base ;
Les figures 17 à 21 : un procédé de fabrication d'un transistor bipolaire à hétérojonction autoalignée selon un troisième mode de réalisation de l'invention ;
La figure 22 : des modes de réalisation de dispositifs illustrant la généralité de l'invention.

Dans la suite de la description, on va décrire un mode de réalisation d'un transistor bipolaire à hétérojonction GaAlAs/ GaAs, autoaligné et de structure mésa.

Selon l'invention, le procédé de fabrication d'un transistor utilise en plus des étapes habituelles de constitution des couches épitaxiées de départ, trois étapes principales respectivement d'isolation initiale, d'épitaxie pour contacter la couche de type N et d'épitaxie pour contacter la couche de base de type P. En particulier, dans cette dernière étape, il est possible de réaliser un dopage important pour obtenir une base GaAs de type P fortement dopée.

Pour réaliser l'isolation initiale, la présente invention propose trois modes de réalisation principaux possibles.

Selon un premier mode de réalisation, on utilise un substrat semi-isolant sur lequel l'épitaxie de l'ensemble des couches du transistor est réalisée. On définit ensuite un masque de protection des zones actives du transistor et on grave les couches pour atteindre le substrat. Ensuite, on réalise une épitaxie sélective vis à vis du masque d'un isolant ou semi-isolant. Cette épitaxie sélective est réalisée avec tous matériaux compatibles avec le fonctionnement du transistor.

Dans un second mode de réalisation, on utilise un substrat semi-isolant dans lequel on réalise des trous grâce à un masque convenable; puis on effectue une épitaxie sélective vis à vis du masque, de l'ensemble des couches du transistor.

En fait, ce second mode de réalisation est constitué par l'inversion de l'ordre des étapes de la méthode précédente.

Selon un troisième mode de réalisation de l'étape d'isolation initiale, on délimite par un masque, d'épaisseur fine, les zones où l'on veut réaliser les transistors sur le circuit intégré. Puis, on effectue une épitaxie non sélective de telle sorte que le film qui croît sur le masque, soit un polycristal semi-isolant. Le film qui croît sur les parties non masquées est cristallin, et permet la réalisation de la structure du transistor.

Pour la seconde étape principale du procédé de l'invention, on définit par un masque, un trou qui permet d'atteindre la couche de contact de type N. Pour isoler les flancs de ces trous, on réalise des espaceurs par gravure plasma d'un matériau isolant préalablement déposé. Selon un autre mode de réalisation, on effectue l'isolation par une implantation après l'épitaxie. On effectue dans ce trou une épitaxie sélective d'une couche conductrice qui se termine par une couche de GaInAs pour réaliser un contact ohmique en tungstène. Selon un autre mode de réalisation, il est possible d'effectuer une épitaxie sélective d'un métal sur la couche GaAs. D'autres formes de dépôts métalliques sont envisageables.

Dans la troisième étape principale du procédé de fabrication de l'invention, on réalise une épitaxie pour contacter ou réaliser le contact avec la base de type P. Cette épitaxie est réalisée après la gravure du mésa d'émetteur. Elle est constituée par un composé GaAs de type P fortement dopé.

L'invention concerne aussi un procédé de fabrication d'un circuit intégré constitué par un pluralité de zones constituées par exemple par des structures actives à base de transistors et de structures passives à base de résistances pour réaliser des cellules de circuit intégré. Pour réaliser des éléments de connexion entre structures, on réalise ou bien une étape de diffusion de zinc pour contacter la base, ou bien une étape de reprise d'épitaxie de type P pour remonter la base. On réalise d'autre part, une étape de reprise d'épitaxie pour contacter la couche de type N.

L'épitaxie destinée à réaliser l'isolation initiale permet d'exécuter, par une conception appropriée des masques liés à cette étape, des blocs de dispositifs actifs à base de transistors à hétérojonction selon l'invention et d'autres encore, et des blocs de dispositifs passifs comme des résistances, pour réaliser des cellules de circuit.

On va maintenant décrire le produit obtenu à l'aide du procédé de fabrication de l'invention pour un transistor bipolaire NPN sur un substrat semi-isolant GaAs selon un mode de réalisation de l'invention.

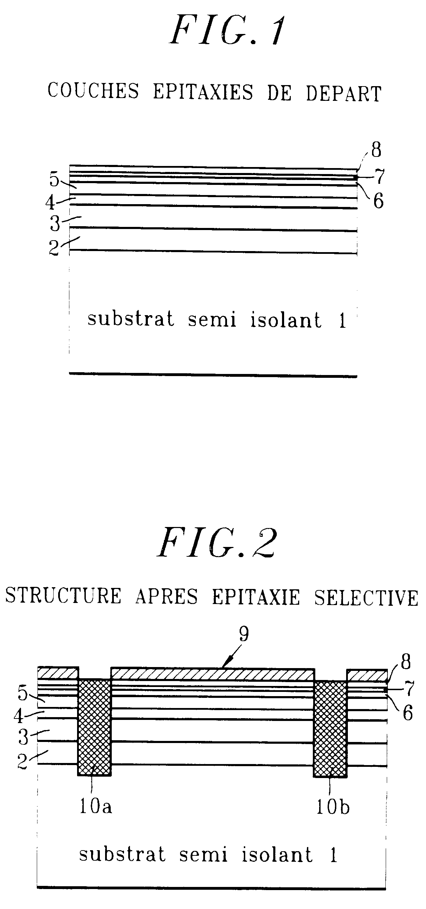

A la figure 1, on réalise des épitaxies successives sur le substrat semi-isolant pour obtenir la structure du transistor comme indiqué ci-dessous. Les dopages et épaisseurs sont indicatifs et peuvent être changés pour adapter les performances du dispositif.

Sur le substrat 1 en GaAs, on réalise une épitaxie en GaAs fortement dopée de type N à une concentration de l'ordre de 4.10¹⁸ atomes. cm⁻³. La couche 2 constitue la couche de contact de collecteur. Son épaisseur est de l'ordre de 50 10⁻⁶ cm.

On réalise ensuite une couche 3 en GaAs, faiblement dopée et de type N avec une concentration de l'ordre de 10¹⁶ atomes. cm⁻³. Cette couche constitue le collecteur proprement dit. Son épaisseur est de l'ordre de 45 10⁻⁶ cm.

On réalise ensuite par épitaxie une couche 4 en GaAs. Dans un mode de réalisation, on exécute aussi une gradualité d'aluminium, la couche 4 devenant une couche en Ga₁₋ₓAlₓAs, avec x variant par exemple de 0 à 0,15 quand on part de la couche inférieure 3. La gradualité d'aluminium d'une valeur a à une valeur b permet d'améliorer les performances fréquentielles du circuit intégré. Dans un autre mode, la couche 4 est sans gradualité d'aluminium Al.

Dans les deux modes de réalisation précités, le dopage est de type P le plus élevé possible, par exemple de l'ordre de 10²⁰ atomes/ cm³ pour diminuer la résistance de cette couche. La couche 4 constitue la base proprement dite du transistor bipolaire.

L'épaisseur de la couche 4 résulte d'un compromis entre la nécessité de la diminuer pour faire décroître le temps de transit des électrons au travers de cette couche, et la nécessité d'augmenter cette épaisseur pour diminuer la résistance de la couche.

La couche 5 suivante est réalisée par épitaxie en Ga₁₋ₓA ₓAs. Elle constitue la couche d'émetteur. Dans un mode de réalisation, x est égal à 30% d'aluminium. La couche est faiblement dopée par des impuretés de type N à une concentration de 10¹⁷ atomes. cm⁻³ et 15 10⁻⁶ cm d'épaisseur. Cette couche 5 comporte des gradualités en aluminium à ses deux extrémités vers les couches 4 et 6, respectivement.

La succession des couches 6, 7 et 8 suivantes constitue la prise de contact de l'émetteur.

La couche 6 est réalisée par épitaxie en GaAs, dopée par des impuretés de type N sur une concentration de l'ordre de 2 x 10¹⁸ atomes. cm⁻³ et 50 nanomètres d'épaisseur. On réalise ensuite l'épitaxie de la couche 7 en GaInAs avec gradualité d'indium de 0 % à 65 % et dopage par des impuretés de type N de l'ordre de 2 à 5 x 10¹⁹ atomes. cm⁻³ et sur 50 nanomètres d'épaisseur. Enfin, on réalise une épitaxie de la couche 8 en GaInAs à 65 % d'indium et 35 % de gallium, avec un dopage de type N de l'ordre de 2 à 5 10¹⁹ atomes. cm⁻³ et 50 nanomètres d'épaisseur. Cette étape voit la fin de la réalisation des couches épitaxiées de départ.

Dans la suite de la réalisation du procédé de l'invention, telle qu'elle est représentée à la figure 2, on réalise un dépôt d'un matériau isolant 9 (SiO₂, Si₃N₄) réparti sur toute la surface de la couche 8 supérieure du transistor.

En particulier, la couche de matériau isolant 9 est répartie sur toute la surface supérieure du circuit intégré quand l'invention est appliquée à un tel dispositif. Si le circuit intégré est destiné à recevoir des implantations d'autres produits que des transistors bipolaires, le dépôt du matériau isolant peut être localisé aux zones du circuit intégré qui sont destinées à produire un ou plusieurs transistors bipolaires à hétérojonction selon l'invention.

Ensuite, on réalise un masquage, par exemple avec un film photoresist, et on effectue une gravure de cet isolant et des couches du transistor pour atteindre le substrat semi-isolant 1 de façon à circonscrire des zones actives destinées à recevoir chacune au moins un transistor selon l'invention.

Ensuite, on réalise une épitaxie sélective vis à vis de l'isolant 9 avec un matériau semi-isolant (InP ou GaInP dopé au fer) ou isolant 10. De ce fait, le transistor est constitué par le substrat semi-isolant 1 et l'empilement des couches 2 à 8, et il est isolé par des caissons 10A et 10B à la figure 2. De ce fait, la zone active du transistor T est bien protégée du reste du dispositif, représenté après épitaxie sélective.

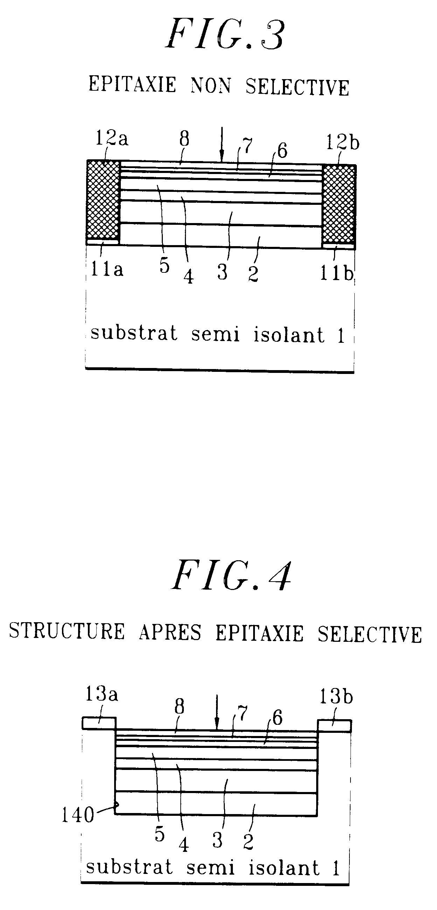

A la figure 3, on a représenté un second mode de réalisation d'un transistor selon l'invention. On commence par définir la zone active du transistor par gravure d'un isolant 11A et 11B (SiO₂, Si₃N₄), initialement déposé sur le substrat semi-isolant 1. Une épitaxie non sélective des couches du transistor, analogue à celle réalisée à la figure 1 est alors exécutée. On obtient ainsi, sur l'isolant 11A et 11B, la croissance d'un polycristal isolant selon deux caissons isolants 12A, 12B et la croissance d'un cristal dans la zone sans isolant qui constitue la zone active du transistor.

A la figure 4, on a représenté un troisième mode de réalisation selon un procédé de l'invention.

Selon ce procédé de fabrication, on réalise un trou 140 dans le semi-isolant 1. Pour cela, on dépose sur le semi-isolant 1 une couche isolante 13. Puis par masquage, on réalise une gravure de l'isolant 13, puis du substrat semi-isolant 1.

On effectue ensuite une épitaxie sélective dans le trou 140 des différentes couches du transistor analogues à celles représentées à la figure 1. De ce fait, après l'exécution, la zone active qui matérialise le transistor est contenue dans un puits 140 creusé dans l'épaisseur du substrat semi- isolant 1.

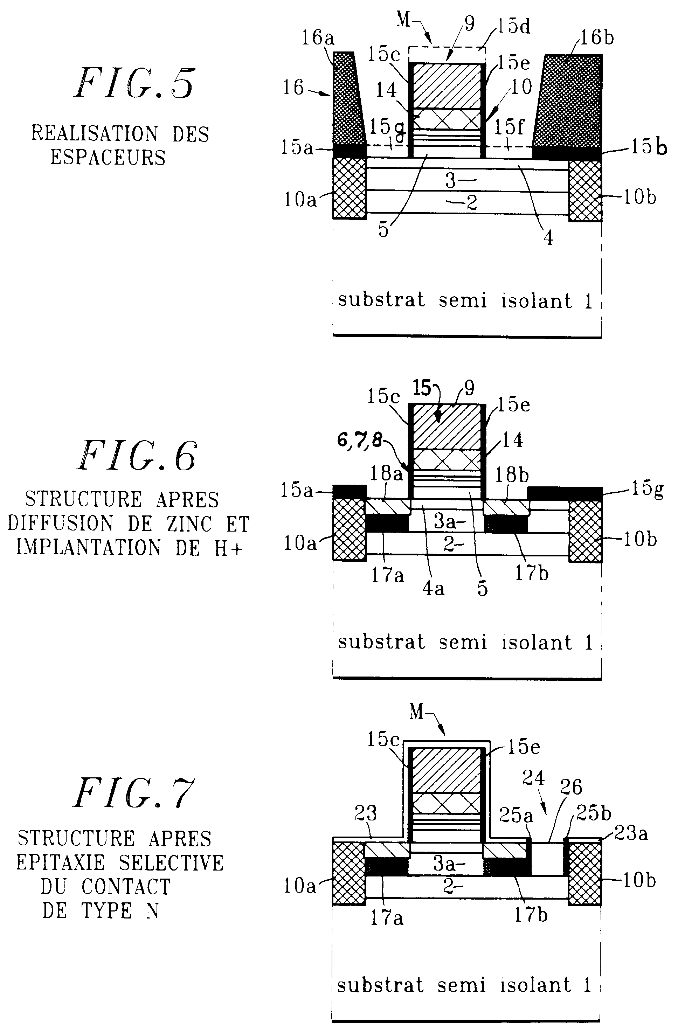

Aux figures 5 à 9, on a représenté un premier mode de réalisation de la seconde étape principale du procédé de fabrication selon l'invention. Les différentes étapes constitutives de la seconde étape principale sont décrites quand on utilise, la structure obtenue suite à l'exécution de la première étape principale du procédé de fabrication, et représentée à la figure 2. Chacune des étapes constitutives de la seconde étape principale peut être adaptée aux deux autres modes de réalisation de la première étape principale, aux structures représentées respectivement aux figures 3 et 4.

A la figure 5, on réalise d'abord l'élimination de l'isolant 9 (quand on part du procédé de la figure 3) ou des caissons 13A et 13B (quand on part du procédé de la figure 4).

On dépose ensuite une couche de tungstène 14, ou de tout autre matériau réfractaire conducteur susceptible de réaliser un contact ohmique sur du GaInAs. Cette couche est représentée partiellement à la fin de l'étape représentée à la figure 5.

Puis, on ajoute une couche d'un matériau isolant 15 (SiO₂ Si₃N₄) et une couche de résine 16 photosensible.

Enfin, on réalise par gravure anisotrope un mésa d'émetteur. Cette gravure est arrêtée avant d'atteindre la couche de base 4, à 1000 Angströms de celle-ci pour la protéger. A l'aide d'un masque, on définit par gravure les espaceurs 15c et 15e sur le mésa M d'émetteur. A la figure 5, la couche de résine photosensible 16 subsiste de part et d'autre du trou de masquage en parties 16a et 16b. Les parties 15g, 15d et 15f de la couche 15, qui a servi à réaliser les espaceurs 15c et 15e du mésa M sont éliminées par la gravure.

Sur la figure 5, la couche fine d'émetteur de 1000 Angströms n'est pas représentée.

A la figure 6, la dernière gravure de la figure 5 permet également de délimiter à la fois la zone où est effectuée une diffusion de zinc pour faire le contact avec la couche de base, et de délimiter la zone où est effectuée l'implantation des protons pour diminuer la capacité base-collecteur, c'est à dire plus généralement la capacité entre la couche du premier type de conductivité et la couche du second type de conductivité.

La structure après diffusion de zinc et implantation des protons est représentée à la figure 6. A la figure 6, l'ilôt ou mésa d'émetteur M, au-dessus de la structure plane, est constitué principalement par l'isolant 15, les deux espaceurs latéraux 15c et 15e isolants et les couches actives 6, 7 et 8, ainsi que la couche 14 de contact en Tungstène.

De part et d'autre au mésa M, on effectue successivement une diffusion de zinc et une implantation de protons. Deux zones 17a et 17b d'implantation de protons sont réalisées de chaque coté de la couche 3 de collecteur (ou du premier type de conductivité) à proximité des caissons d'isolation 10a et 10b. Deux zones 18a et 18b dans la couche 4 de chaque coté du mésa sont réalisées par la diffusion de zinc et partiellement dans la couche 3 de collecteur (ou de second type de conductivité).

La couche 3 présente ainsi une première partie active 3a sous le mésa d'émetteur, et deux parties adjacentes 17a et 17b d'implantation de protons dans le collecteur qui servent à réduire la capacité base-collecteur du transistor.

La couche 4 présente au dessus des trois parties actives précitées 3a et 17a, 17b, trois parties réciproques 4a et 18a, 18b. Les parties réciproques 18a, 18b servent d'accès à la base 4a et permettent ainsi de réaliser un contact ohmique de base 4.

On remarque ainsi que les remontées en surface des parties de contactage selon l'invention peuvent recevoir des traitements pour améliorer leurs performances selon tout procédé connu de l'homme de métier.

A la figure 7, on a représenté l'état de la structure après élimination des zones isolantes 15a et 15b par gravure anisotrope. Ce procédé de gravure anisotrope n'élimine pas les espaceurs sur l'émetteur parce que la vitesse de gravure dans le sens vertical est beaucoup plus important que dans le sens horizontal. Ensuite, on dépose de nouveau une couche d'isolant 23 (SiO₂, Si₃N₄).

Ensuite, à l'aide d'un masque, on effectue une gravure anisotrope pour constituer un trou 24 pour atteindre la couche de contact du collecteur. On réalise ensuite des espaceurs 25a et 25b (SiO₂, Si₃N₄) sur les parois latérales du trou 24. Le trou reçoit une reprise d'épitaxie sélective d'une couche de contact 26 peu résistive pour faire remonter le contactage du collecteur en surface. Cette nouvelle épitaxie est constituée successivement de GaAs dopée par une impureté de type N en concentration de 4 10¹⁸ atomes, puis de GaInAs, à fort dopage d'impuretés et avec gradualité d'indium de 0 à 65 %, et enfin de GaInAs, fortement dopé par des impuretés de type N, avec 65 % d'indium et 35 % de gallium.

Cette dernière couche en surface pe±met de réaliser un contact en tungstène pour le collecteur.

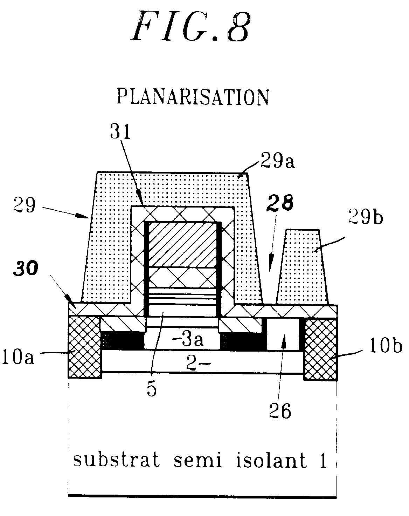

A la figure 8, on a réalisé un dépôt de tungstène. La couche de tungstène 30 est répartie , de façon quasi uniforme sur la surface du dispositif. En particulier, la couche de tungstène recouvre les cloisons d'isolation 10a et 10b ainsi que les parties actives du transistor.

On dépose sur la surface de la structure en cours de fabrication, une couche d'une résine photo-sensible 29 présentant au moins un plot 29a au-dessus de la protubérance, au-dessus de la partie active du transistor et une protubérance 29b au-dessus partiellement du contact de collecteur dans le puits 24. L'espace 28 entre les deux plots 29a et 29b permet de découper par gravure sélective une découpe assurant la séparation des contacts de collecteur et de base.

On grave avec un agent de gravure commun à la fois les épaisseurs de résine et de tungstène. On élimine ainsi le tungstène sur le mésa d'émetteur et au niveau de l'ouverture 28, ce qui réalise la séparation des contacts de base et de collecteur.

Dans une seconde variante, on peut effectuer deux étapes technologiques distinctes pour éliminer le tungstène au dessus du mésa d'émetteur d'une part, et séparer les contacts de base et de collecteur par gravure du tungstène d'autre part. On obtient ainsi le même résultat final.

D'une manière générale, on dispose de deux procédures possibles pour réaliser cette opération. Selon un premier mode de réalisation, on effectue une planarisation du tungstène par gravure d'une couche de résine sacrificielle. Dans une seconde étape, à l'aide d'une photolithographie, on définit les contacts de base et de collecteur. Ce mode de réalisation sera représenté plus loin dans un autre mode de réalisation de l'invention. Selon une seconde procédure, on effectue simultanément la planarisation et la définition des contacts de base et des collecteurs, ce qui a été représenté à la figure 8.

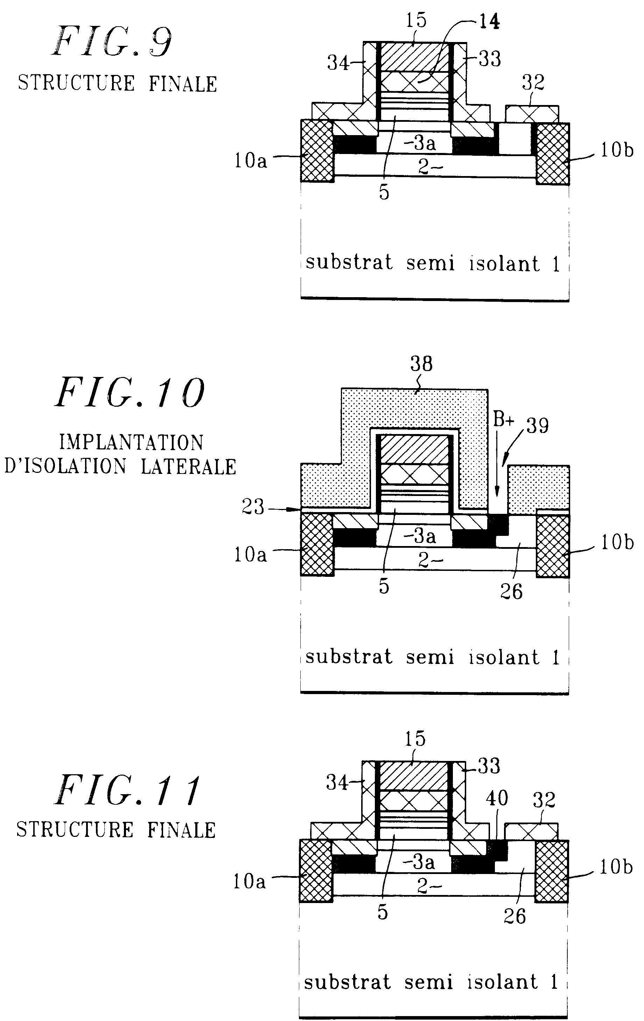

A la figure 9, on a représenté la structure définitive. La structure définitive comporte une partie active de transistor entre deux caissons d'isolation 10a et 10b. La partie active de transistor comporte sur la surface de dessus les contacts 14, 32, 33 et 34 respectivement d'émetteur, de collecteur et de base, avec le mésa d'émetteur.

Dans un autre mode de réalisation de l'invention, on évite d'utiliser au préalable les espaceurs comme dans le cas de la figure 7. A la figure 10, on a déposé une résine photosensible 38 sur la couche 23 d'isolation sur laquelle a été révélé un puits 39. Le puits 39 est disposé à la limite entre l'espaceur 25a et le puits 24 de la figure 7. Puis, on a réalisé une isolation 40 par implantation d'ions de bore ou de protons.

Dans ce procédé, en répétant les étapes de la figure 8, on obtient une structure finale 11 dans laquelle le contact de collecteur est remonté par une épitaxie sélective 26.

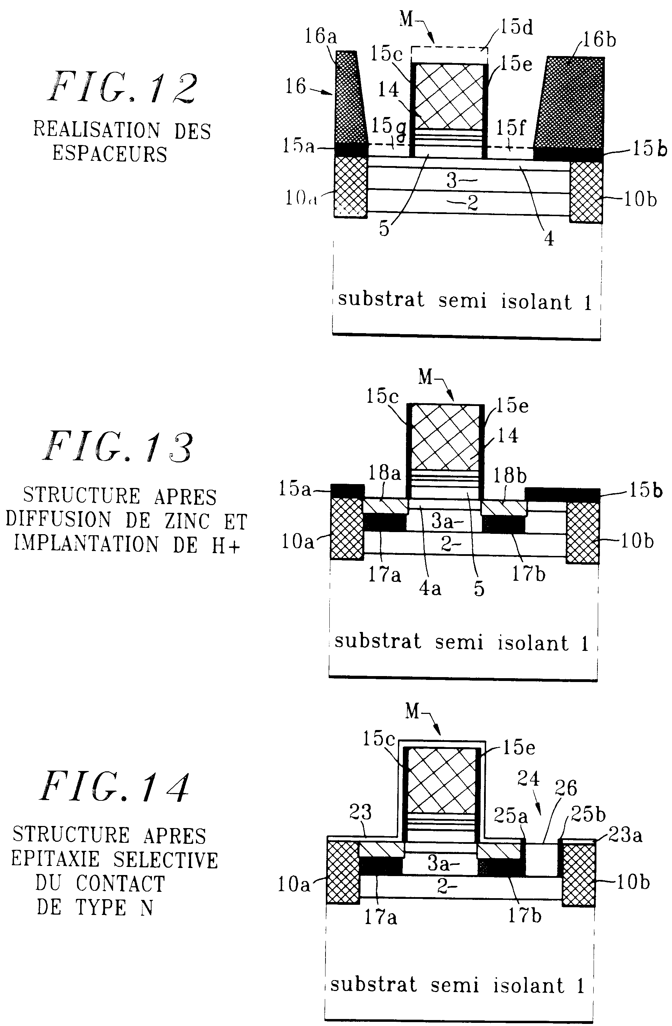

Aux figures 12 à 16, on a représenté une variante de la procédure représentée aux figures 5 à 9 ou 10 et 11, et qui permet d'obtenir une structure totalement plane sans passer par une reprise d'épitaxie de la base. A la figure 12, on répète le procédé de fabrication décrit à la figure 5. Cependant, la couche de tungstène initiale est plus épaisse et l'on n'utilise pas d'isolant 15 sur le dessus du mésa d'émetteur. L'épaisseur de la couche de tungstène 14 est telle que sa surface de dessus atteint au moins la pleine hauteur du dispositif final.

A la figure 13, on répète les opérations décrites lors du mode de réalisation du procédé de fabrication représenté et commenté à la figure 6.

A la figure 14, on répète les opérations décrites lors du mode de réalisation du procédé de fabrication représenté et commenté à la figure 7.

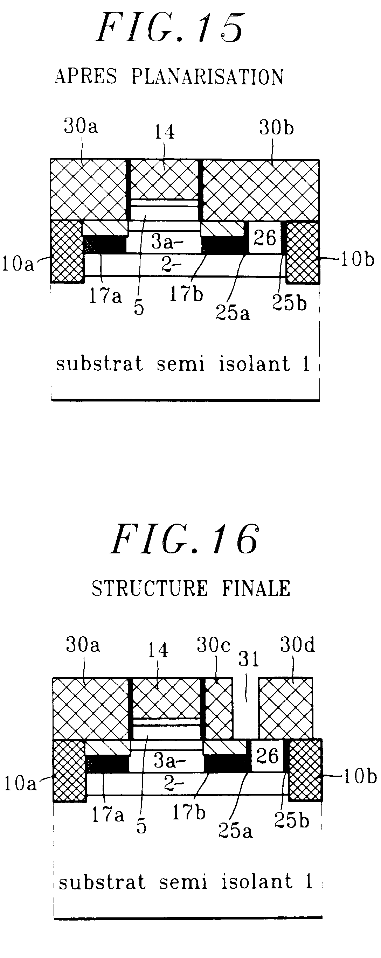

A la figure 15, on dépose une seconde couche de tungstène épaisse qui, après planarisation, comporte une première partie 30a à gauche du mésa M et une seconde partie 30b à droite du mésa M. La hauteur de la seconde couche de tungstène 30a, 30b est telle qu'à la fin du procédé de fabrication, les surfaces de dessus des couches de tungstène 30a, 30b et 14 soient au même niveau. A cette fin, dans une étape antérieure, on a réalisé une planarisation par gravure simultanée d'une résine préalablement déposée et du tungstène, selon l'un des modes opératoires décrit à la figure 8. Les espaceurs 15c et 15e réalisent l'isolation entre les couches 30a, 30b et 14.

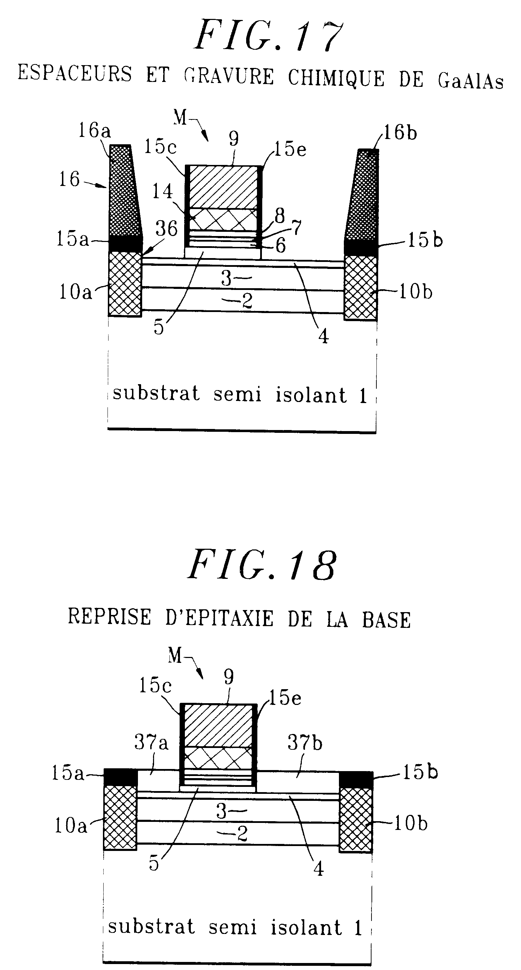

A la figure 16, on a réalisé à l'aide d'un masque la séparation par gravure des contacts de base 30c et de collecteur et 30d réalisés dans la partie 30b de la couche de tungstène 30a, 30b.

Aux figures 17 à 22, on a représenté un autre mode de réalisation du procédé de réalisation d'un transistor bipolaire à hétérojonction autoaligné. A la figure 17, on a repris le procédé de fabrication décrit précédemment à la figure 5. La différence est que la gravure chimique a été utilisée après la réalisation des espaceurs pour graver la fine couche d'émetteur qui subsiste après gravure du mésa d'émetteur, pour effectuer une reprise d'épitaxie sélective de la couche de base.

A la figure 18, on a représenté la reprise d'épitaxie sélective de la couche de base 4 pour ramener la base en surface par une couche épitaxiée 37a et 37b de part et d'autre du mésa d'émetteur M. Cette couche est, dans un exemple préféré de réalisation, réalisée en GaAs dopée sous une concentration de 10²⁰ atomes par cm³.

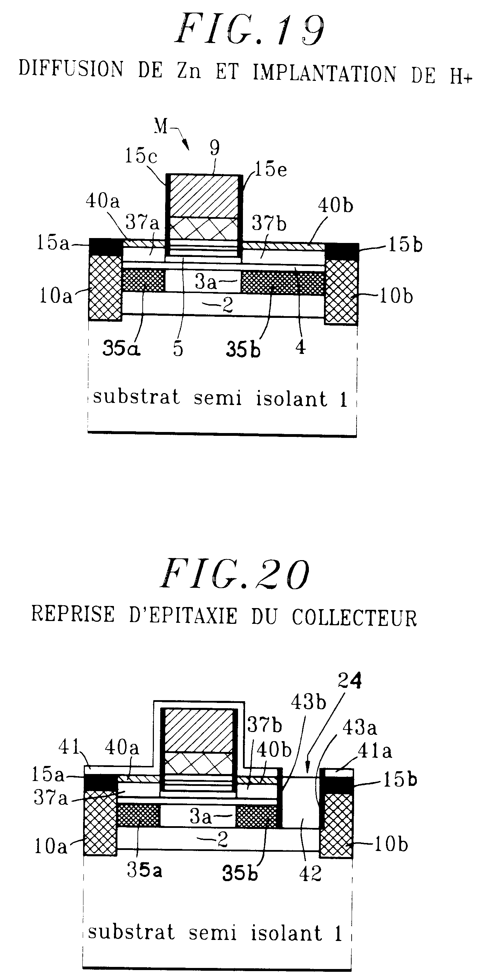

A l'étape représentée à la figure 19, on a réalisé une diffusion de zinc si nécessaire, pour faciliter par des couches 40a et 40b le contact ohmique en tungstène ultérieur. Puis, on effectue une implantation de protons H+ pour diminuer la capacité base- collecteur dans les zones 35a et 35b de façon à constituer une zone centrale de collecteur 3a.

A l'étape représentée à la figure 20, on dépose un isolant 41 à la surface supérieure du dispositif. Puis, on définit une ouverture 24, ouverture pratiquée par photolithographie. On effectue une gravure pour réaliser le contact de la couche de contact de collecteur.

Après formation des espaceurs 43a et 43b dans le trou 24, on effectue une reprise d'épitaxie sélective 26 analogue à celle décrite dans la procédure n°1 à la figure 7.

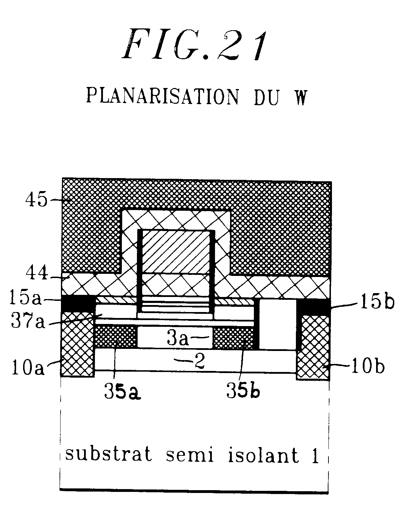

A la figure 21, on a repris la technique représentée à la figure 8. Selon cette technique, on réalise la planarisation du tungstène et la séparation des contacts de base et de collecteur en deux étapes. La réalisation de ces deux étapes en seule opération est également possible.

Dans un autre mode de réalisation de l'invention, on dépose sur le substrat une couche d'un matériau déterminé. Puis, on réalise des trous pour atteindre le substrat au travers de cette couche. Puis, on effectue une épitaxie non sélective des couches de l'ensemble des structures actives que l'on souhaite former sur le substrat. En fait, on peut ne former qu'une seule structure active comme un transistor de puissance par exemple. L'épitaxie non sélective permet de réaliser ainsi directement l'isolation entre les dites structures actives par la formation d'un polycristal isolant sur les parties isolantes initialement non gravées.

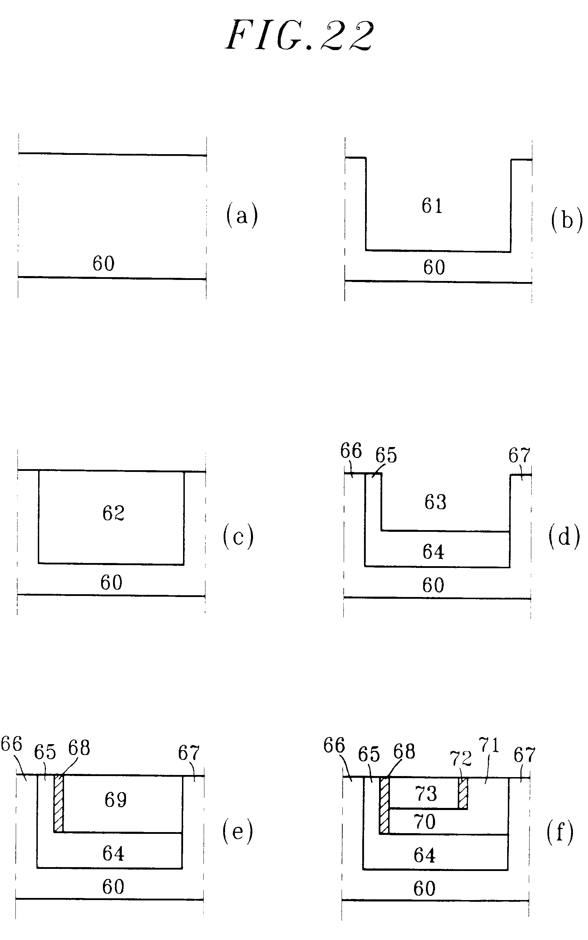

D'une manière générale, l'invention permet de réaliser une structure active plane et auto-alignée, dans laquelle on peut réaliser des contacts ohmiques en un seul métal réfractaire. A la figure 22, on a représenté six étapes de réalisation d'un procédé de fabrication selon l'invention. Dans le mode de réalisation de la figure 22, on a représenté exclusivement la succession des étapes de creusement et de remplissage qui caractérisent l'invention. En particulier, ainsi qu'on l'a vu plus haut, le procédé de l'invention peut se combiner avantageusement avec d'autres procédés de fabrication connus de l'homme de métier. En particulier, les moyens de creusement et de remplissage peuvent être changés par l'homme de métier sans sortir de l'invention.

A l'étape (a) on dispose d'un substrat semi-isolant 60. Ce substrat présente une face supérieure en haut du dessin et accessible pour des moyens de creusement non représentés. En particulier, ces moyens peuvent comporter, le dépôt d'un résine photosensible qui permettra de réaliser un creusement par gravure.

A l'étape (b), on a réalisé par ces moyens connus un creusement 61. La forme de ce creusement dépend du procédé de creusement utilisé. En particulier, il peut prendre toute forme de géométries comme une forme en "V" ou une forme parallélépipédique.

A l'étape (c), on remplit le creusement 61 par un procédé connu avec au moins une couche ou groupe de couches 62. De façon préférée, mais non nécessaire, les creusements 61 sont remplis jusqu'à effleurement. Les couches 62 sont arasées par tout procédé convenable de façon à produire un produit final plan et auto-aligné.

A l'étape (d), on réalise un creusement 63 depuis la surface supérieure dans le remplissage 62. Ce creusement 63 permet de constituer en particulier une remontée 65 de la couche ou de la couche supérieure d'un groupe de couches 64 à partir du remplissage 62 de l'étape (c). On remarque aussi que la structure active constituée dans le creusement 61 initial sera isolée du reste des structures actives déposées dans le substrat 60 par des parties isolantes 66 et 67 qui sont constituées par le substrat semi- isolant de départ et constituent les parois du creusement 61 initial.

Par des moyens connus, lors de l'étape (e), on dispose sur au moins une paroi verticale du creusement 63, un espaceur isolant 68. Puis, on réalise un second remplissage par une couche ou groupe de couches 69.

A l'étape (f), on exécute un creusement non représenté, sur au moins une paroi verticale duquel on dépose un espaceur isolant vertical 72. On exécute ensuite par les mêmes moyens connus, un remplissage par une couche ou groupe de couches 73.

On dispose ainsi à la surface de la structure active finale des sections de surface d'isolement 66 et 67, ainsi que des surfaces de contactage 65, 73 et 71 qui permettent de contacter depuis la surface supérieure l'ensemble des couches actives de la structure active.

Ainsi, selon l'invention, on sait fabriquer un transistor bipolaire à hétérojonction, comportant au moins une hétérojonction. Un tel transistor comporte une couche d'émetteur (5), une couche de base (4) et une couche de collecteur (3). La couche de collecteur est en contact électrique avec des moyens de contactage de collecteur (2, 26). La couche de base (4) est en contact électrique avec des moyens de contactage de base (17a, 17b, 18a, 18b). Les moyens de contactage présentent une couche finale (30) réalisée en matériau réfractaire comme du tungstène. Toute la surface supérieure de cette couche finale est a un même niveau, ce qui assure sa planèité. On remarque que cette structure s'adapte à d'autres structures actives que le transistor ou que le transistor bipolaire à hétérojonction.

Dans le but d'intégration, le procédé de l'invention permet de produire un dispositif semiconducteur qui intègre au moins une structure active comme un transistor bipolaire à hétérojonction ainsi obtenu. Ce circuit intégré peut donc en particulier être hybride ou mixte et composer plusieurs technologies sur un même substrat.

Dans un tel circuit intégré, un dispositif selon l'invention est réalisé par interconnexion équisurface entre plusieurs structures actives comme des structures bipolaires à hétérojonction planes et autoalignées.

## Revendications

1. Procédé de fabrication de structures actives ou d'au moins une structure active, semiconductrices multicouches en matériau III-V sur un substrat (60), caractérisé en ce qu'il consiste à réaliser une succession de creusements (61, 63) et de remplissages (62, 69, 73) des dits creusements (61, 63) ainsi réalisés à l'aide d'épitaxies sélectives d'au moins un matériau correspondant à l'une des dites couches ou groupe de couches, de telle sorte que, à chaque étape de remplissage, on réalise la remontée en surface de la structure finale d'une partie de contactage (65, 71 ; 73 ) d'au moins une couche (64, 70) ou groupe de couches et/ ou une isolation (66, 67) desdites structures actives.

2. Procédé selon la revendication 1, caractérisé en ce que le remplissage d'un creusement est réalisé par reprise d'épitaxie (10a, 10b) depuis la couche la plus profonde dégagée dans le creusement jusqu'au niveau de surface.

3. Procédé selon la revendication 1, caractérisé en ce que, quand la structure active est réalisée sur un substrat semi-isolant, on réalise directement l'isolation (66, 67) entre structures actives voisines d'un circuit intégré par creusements du substrat semi-isolant selon plusieurs creux (61, 63) de façon à faire apparaitre à sa surface l'ensemble des structures actives dont le remplissage ultérieur réalise un réseau de structures actives, puis qu 'on réalise une étape pour les relier électriquement, ou autrement les unes aux autres les dites structures actives, pour réaliser des circuits intégrés complexes.

4. Procédé selon la revendication 1, caractérisé en ce que, quand la structure active est réalisée sur un substrat semi- isolant, pour réaliser directement l'isolation entre structures actives voisines d'un circuit intégré, on réalise dans une première étape une pluralité de structures actives (6, 7, 8) au-dessus d'au moins une partie correspondante du substrat, puis dans une seconde étape, on exécute un creusement dans des zones de séparation électrique entre deux structures actives, puis dans une troisième étape, pour réaliser l'isolation, on réalise une reprise sélective d'épitaxie (10A, 10B) du matériau du substrat de façon à remplir chacun des dits creux par épitaxie d'un matériau semi- isolant ou isolant.

5. Procédé selon la revendication 1, caractérisé en ce que on réalise des trous pour atteindre le substrat au travers d'une couche d'un matériau préalablement déposée sur le substrat ; puis, on effectue une épitaxie non sélective des couches (2-8) d'au moins une structure active, de façon à réaliser ainsi directement l'isolation (12A, 12B) entre les dites structures actives par la formation d'un polycristal isolant sur les parties isolantes initialement non gravées.

6. Procédé selon l'une des revendications précédentes, caractérisé en ce que on réalise des trous par masquage sur un substrat de pleine hauteur ; puis, dans ces trous, on vient implanter par épitaxies sélectives successives l'empilement des couches (2-8) de chacune des structures actives à disposer sur le circuit intégré ; puis, on réalise une étape de creusement (24) en des zones prédéterminées de façon à atteindre les couches à contacter; puis, par reprises d'épitaxies sélectives, on fait remonter le matériau (26) de la couche à contacter à la surface de la structure finale ; puis, on réalise ultérieurement une étape de connexion électrique (28) comme un contact ohmique.

7. Procédé selon l'une des revendications 1 à 6, caractérisé en ce qu'on réalise des espaceurs isolants (15c, 15e) sur les parois verticales du creusement pour réaliser une isolation locale de la remontée de connexion de contact.

8. Procédé selon l'une des revendications précédentes, de fabrication d'au moins une structure active présentant au moins un substrat semi- isolant, sur lequel sont empilées au moins une couche d'un premier type de conductivité (type N ; collecteur 3) et une couche d'un second type de conductivité (type P ; base 4), comme un transistor bipolaire à hétérojonction, et qui se caractérise principalement en ce que :
on réalise une isolation initiale à partir d'un substrat semi- isolant ;
on réalise un creusement, puis une reprise d'épitaxie pour contacter la couche du premier type de conductivité (type N ; collecteur 3) ; et
on réalise un creusement, puis une reprise d'épitaxie pour contacter la couche du second type de conductivité (type P ; base 4).

9. Procédé selon la revendication 8, caractérisé en ce que, on réalise, après avoir déposé une couche (14) de tungstène pour réaliser le contactage de l'émetteur, par gravure anisotrope, un mésa d'émetteur (M), la gravure étant arrêtée avant d'atteindre la couche du second type de conductivité ( type P ; base 4), pour protéger celle-ci ;
on dépose alors un isolant (15) ;
on définit par gravure, à l'aide d'un masque, des espaceurs (15c, 15e) sur le mésa (M) d'émetteur de façon à ce que la couche d'isolant (15) subsiste de part et d'autre du trou de masquage en parties (15a et 15b), puis que les parties (15g, 15d et 15f) de la couche (15), qui a servi à réaliser les espaceurs (15c, 15e) du mésa M, sont éliminées par la gravure.

10. Procédé selon la revendication 9, caractérisé en ce que la dernière gravure permet également de délimiter à la fois au moins une zone (18a, 18b) où est effectuée une diffusion de zinc pour faire le contact avec la couche du second type de conductivité (base 4, type P), et de délimiter au moins une zone (17a, 17b) où est effectuée une implantation de protons pour diminuer la capacité entre les deux couches de conductivités opposées (base 4 - collecteur 3).

11. Procédé selon les revendications 8 et 9, caractérisé en ce que :
on dépose une couche d'isolation complète (23) ;
on effectue à l'aide d'un masque une gravure anisotrope pour constituer un trou (24) pour atteindre une couche de contactage (2) du collecteur (3) ;
on réalise ensuite des espaceurs (25a et 25b) sur les parois latérales du trou (24) ;
on réalise pour le trou une reprise d'épitaxie sélective d'une couche de contact (26) peu résistive pour faire remonter le contactage du collecteur en surface.

12. Procédé selon la revendication 11, caractérisé en ce que la dite reprise d'épitaxie est constituée successivement de GaAs dopé par une impureté en concentration de 4 10¹⁸ atomes, puis de GaIAs, à fort dopage d'impuretés et avec gradualité d'indium de a à b % (avec b>a), et enfin de GaInAs, fortement dopé par des impuretés de type N, avec b % d'indium et (1 - b) % de gallium de façon à ce que cette dernière couche en surface permette de réaliser un contact en tungstène pour le collecteur.

13. Procédé selon la revendication 11, caractérisé en ce que :
on réalise un dépôt de tungstène en une couche (30), de façon quasi uniforme sur la surface de la structure ;
on dispose sur la surface de la structure en cours de fabrication, une couche d'une résine photosensible (29) présentant au moins un plot (29a) au dessus du mésa (M) et au-dessus de la partie active du transistor et un plot (29b) au moins partiellement au-dessus du contact de collecteur dans le puits (24), en pratiquant un espace (28) entre les deux plots (29a et 29b) de façon à permettre de découper par gravure sélective une découpe assurant les contacts de collecteur et de base ;
on réalise une gravure simultannée de la couche de tungstène (30) et de la couche photosensible (29a) de façon à supprimer la seule partie (31) horizontale disposée au-dessus du mésa (M), en gravant le tungstène dans l'espace (ou ouverture) (28) .

14. Procédé selon la revendication 13, caractérisé en ce que on effectue une planarisation du tungstène par gravure d'une couche de résine sacrificielle ;
à l'aide d'une photolithographie, on définit les contacts de base et de collecteur (figure 8).

15. Procédé selon la revendication 11, caractérisé en ce que après avoir déposé la couche (23) d'isolation complète, on dépose une résine photosensible (38) sur laquelle a été révélé un puits (39), disposé à la limite entre l'espaceur (25a) et le puits (24) ; puis, on réalise une isolation du puits par implantation d'ions de bore ou de protons.

16. Procédé selon la revendication 8, caractérisé en ce que la couche de tungstène initialement déposée (14) est plus épaisse que nécessaire au contactage et en ce que l'on n'utilise pas d'isolant (9) sur le dessus du mésa d'émetteur, l'épaisseur de la couche de tungstène (14) étant telle que sa surface de dessus atteint au moins la pleine hauteur du dispositif final.

17. Procédé selon les revendications 16 et 12 à 14, caractérisé en ce que on dépose une seconde couche de tungstène épaisse (30a, 30b), on réalise une planarisation par gravure simultannée d'une résine préalablement déposée et du tungstène de façon à ce que la hauteur de la seconde couche de tungstène (30a, 30b), ainsi séparée en deux parties à droite (30a) du mésa d'émetteur (M) et à gauche (30b) du mésa d'émetteur (30b), soit telle qu'à la fin du procédé de fabrication, les surfaces de dessus des couches de tungstène (30a, 30b et 14) soient au même niveau, la première couche de tungstène (14) étant séparée des parties (30a et 30b) de la seconde couche de tungstène par des espaceurs (15c, 15e).

18. Procédé selon la revendication 17, caractérisé en ce que on réalise à l'aide d'un masque la séparation par gravure des contacts de base (30c) et de collecteur (30d) réalisés dans la seconde partie (30b) de la couche de tungstène (30a, 30b).

19. Procédé selon l'une des revendications précédentes, caractérisé en ce que, si le substrat (1) porte plusieurs zones actives, le procédé est répété ou multiplié par des moyens connus pour chaque structure active.

20. Transistor bipolaire à hétérojonction, comportant au moins une hétérojonction et fabriqué selon le procédé des revendications 1 à 19, caractérisé en ce qu'il comporte une couche d'émetteur (5), une couche de base (4) et une couche de collecteur (3), la couche de collecteur étant en contact électrique avec des moyens de contactage de collecteur (2, 26) et la couche de base (4) étant en contact électrique avec des moyens de contactage de base (17a, 17b, 18a, 18b), dont la couche finale (30) est réalisée en matériau réfractaire et dont toute la surface supérieure est au même niveau.

21. Dispositif semiconducteur, caractérisé en ce qu'il est obtenu par le procédé selon l'une des revendications 1 à 19 ou en ce qu'il intègre au moins une structure active comme un transistor selon la revendication 20.

22. Dispositif selon la revendication 21, caractérisé en ce qu'il est réalisé par interconnexion équisurface entre plusieurs structures actives comme des structures bipolaires à hétérojonction planes et autoalignées.
